# EUROPEAN PATENT APPLICATION

(11) **EP 4 699 980 A1**
(43) Date of publication of application: **25.02.2026**
(21) Application number: 24195780.2
(22) Date of filing: 22.08.2024
(51) Int. Cl.: C01B 32/20, C01B 17/00, C01B 32/70, H10B 63/00, H10N 70/20, H10N 70/00

(54) **CARBON-SULFUR MATERIAL, ELECTRICAL DEVICE COMPRISING THE SAME AND ITS USE IN A MEMRISTOR DEVICE, AND METHOD OF PREPARATION**

(71) Applicant: Terra Quantum AG, 9000 St. Gallen (CH)
(72) Inventor: Kopelevich, Yakov, St. Gallen 9000 (CH); Vinokour, Valerii, 9000 St. Gallen (CH)
(74) Representative: Lucke, Andreas

(57) **Abstract**

A carbon-sulfur material contains sulfur and carbon. The carbon-sulfur material exhibits a current-voltage characteristic, wherein the voltage is zero when the current through the carbon-sulfur material is zero, and the voltage is hysteretic when the current through the carbon-sulfur material is varied and is non-zero.

## Description

### TECHNICAL FIELD

The disclosure relates to a carbon-sulfur material which exhibits memristor behavior, i.e., a current-voltage characteristic with a "pinched hysteresis loop", and to electrical devices such as a memristor using this material.

### BACKGROUND

The memristor, a non-volatile electronic memory device was proposed in L. O. Chua "Memristor - the missing circuit element", IEEE Trans. Circuit Theory 18, 507 (1971). The article provides a possible definition of the memristor as an electrical device characterized by current-voltage characteristics with a "pinched hysteresis loop", i.e., wherein the voltage is zero at zero current and the voltage is hysteretic when the current is varied and non-zero.

The memristor has been proposed as a fourth fundamental two-terminal circuit element complementing the resistor, the capacitor, and the inductor. Various advanced technologies, such as brain-like artificial intelligence neuromorphic computing systems, highly scalable and low-power neural networks and quantum computing systems, and the corresponding industries could benefit from a practical implementation of a memristor.

### OVERVIEW

In view of the technical problems laid out above, there is a need for an improved material for a memristor and a need for improved electronic devices based on this material. This objective is achieved by a carbon-sulfur material according to claim 1, the electrical device comprising the material according to claim 7, a method for preparing a carbon-sulfur material according to claim 9, and the use of the carbon-sulfur material or of the electrical device in a memristor device according to claim 15.

According to an aspect, a method is provided for preparing a carbon-sulfur material. The method comprises mixing a carbon-containing powder and a sulfur-containing powder into a mixture, such that a mass ratio of sulfur to carbon in the mixture is at least 0.5; and thermally treating the mixture at a first temperature, thereby reducing the mass ratio of sulfur to carbon in the mixture (20), wherein the first temperature is in a range from 130°C to 170°C.

The inventors have realized that the carbon-sulfur material prepared this way surprisingly exhibits a nonlinear electrical resistance. This makes the material useful for applications in electrical devices, e.g. in a memristor or a nonlinear resistor.

More specifically, the material exhibits memristor behavior, i.e. its current voltage characteristics exhibit a pinched hysteresis loop. This makes the material highly suitable and attractive for memristor applications.

The preparation method is economical and technically feasible with little equipment, providing major advantages over carbon-containing material deposited from the gas phase or in vacuum, for example using chemical vapor deposition techniques.

Moreover, the method can use carbon powder, which occurs naturally and is available at low cost, making the method and the resulting material economically even more attractive.

The thermal treatment is conducted at a relatively low temperature of 130 to 170°C, which reduces the cost of energy and allows for the integration with materials with moderate temperature stability (for example for the electrodes).

According to some embodiments, the mass ratio of sulfur to carbon in the mixture prior to thermally treating the mixture at the first temperature is at least 2/3 or is at least 1 or exceeds 1.

According to some embodiments, the mass ratio of sulfur to carbon in the mixture is in a range from 0.5 to 2 or is in a range from 1 to 2 or is in a range from 0.5 to 1.8 or is in a range from 0.5 to 1.9 or is in a range from 1 to 1.9 or is in a range from 0.5 to 1.7 or is in a range from 0.7 to 1.7 or is in a range from 1.1 to 1.9 or is in a range from 1.2 to 1.8 or is in a range from 1.3 to 1.7 or is in a range from 1.6 to 1.7.

According to some embodiments, the mixture is thermally treated for at least 5 minutes or for at least 10 minutes or for at least 15 minutes or for at least 20 minutes or for at least 30 minutes or for at least 1 hour or for at least 2 hours or for at least 5 hours or for at least 10 hours or for at least 15 hours or for at least 20 hours.

Thermally treating the mixture at the first temperature may produces the carbon-sulfur material described below in the context of the next aspect.

The process step of thermally treating the mixture at the first temperature may be performed for a first duration.

The first temperature and the first duration may be selected such that, after thermally treating the mixture at the first temperature, the mass ratio of sulfur to carbon of the carbon-sulfur material corresponds to a preselected mass ratio of sulfur to carbon.

For example, the preselected mass ratio of sulfur to carbon may be in a range from 0.4 to 1; or the preselected mass ratio of sulfur to carbon may be 2/3.

Alternatively, or in addition, the preselected mass ratio of sulfur to carbon may have been preselected to lie in between a lower mass ratio of sulfur to carbon and a higher mass ratio of sulfur to carbon, wherein a carbon-sulfur material, e.g. as described below in the context of the next aspect, with the lower mass ratio of sulfur to carbon implements a high-resistivity state or a high-resistance state, for example at a temperature of 100 K, and a carbon-sulfur material (32), e.g. as described below in the context of the next aspect, with the higher mass ratio of sulfur to carbon implements a low-resistivity state or a low-resistance state, for example at a temperature of 100 K.

The high-resistivity state and/or the high-resistance state may be an insulator-, or a semiconductor-type state.

The low-resistivity state and/or the low-resistance state may be a metal-type state.

Alternatively, or in addition, the preselected mass ratio of sulfur to carbon may have been preselected according to a phase-transition-mass-ratio distinguishing the insulating carbon-sulfur material from the metallic carbon-sulfur material.

The metallic carbon-sulfur material may by characterized by a lower resistance as compared to the resistance of the insulating carbon-sulfur material, e.g. at a temperature of 100 K, for example lower by at least a factor of 2 or by at least a factor of 3 or by at least a factor of 5 or by at least a factor of 10, for example, referring to devices of identical physical dimensions.

The method may further comprise performing a compaction of the thermally treated mixture.

The carbon-sulfur material may correspond to the thermally treated mixture or to the thermally treated mixture after the compaction is performed.

According to some embodiments, the compaction maybe performed at a first pressure of at least 0.1 GPa or of at least 0.3 GPa or at least 0.5 GPa or at least 0.8 GPa or at least 1 GPa.

Compaction provides a feasible and economical technique for shaping the thermally treated mixture flexibly into almost any desired shape, for example using a mold.

The method may further comprise providing at least two electrically conductive electrodes or at least four electrically conductive electrodes in electrical contact with the thermally treated mixture

The sulfur-containing powder may contain elemental sulfur, in particular, at a weight percentage (weight %) of at least 50% or at least 70% or at least 90% or at least 95%.

The carbon-containing powder may contain elemental carbon, in particular, at a weight percentage of at least 50% or at least 70% or at least 90% or at least 95%.

Elemental carbon, in particular, structurally disordered carbon such as disordered, mostly sp2-type carbon, occurs abundantly in nature and thus poses an available and economic starting material for the preparation method.

The carbon-containing powder may contain a plurality of layers comprising sp2-hybridized carbon.

The plurality of layers comprising sp2-hybridized carbon may comprise neighboring layers.

A distance between the neighboring layers may exceed 0.34 nm or 0.345 nm along a direction of a surface normal of at least one of the neighboring layers. In particular, surface normals of the neighboring layers may coincide and/or said direction may be the direction of the surface normals of both or all of the neighboring layers.

The layers comprising sp2-hybridized carbon or the neighboring layers may be curved.

The plurality of layers comprising sp2-hybridized carbon may comprise at least 3 or at least 5 or at least 10 of the respective neighboring layers, for example at respective distances and/or in the form of curved layers.

The inventors have realized that respective layers comprising sp2-hybridized carbon beneficially support the preparation of sulfur carbon material with a nonlinear resistance and/or memristor behavior.

According to some embodiments, the carbon-containing powder contains sp2-hybridized carbon and sp3-hybridized carbon.

The combination of sp2-hybridized carbon and sp3-hybridized carbon results in a type of disorder of the carbon-containing powder that beneficially supports the preparation of sulfur carbon material with a nonlinear resistance and/or memristor behavior.

The carbon-containing powder may comprise or be composed of Shungite and/or carbon-containing material mined in Karelia, Russia.

The respective carbon-containing powder beneficially supports the preparation of sulfur carbon material with a nonlinear assistance and/or memristor behavior.

According to some embodiments, the carbon-containing powder contains grains.

Lengths of the grains may exceed 3 µm or 5 µm or 8 µm. The lengths may be below 200 µm or below 100 µm or below 50 µm.

Thicknesses of the grains may be smaller than 2 µm or smaller than 1 µm or smaller than 0.5 µm.

The carbon-containing powder may contain the respective grains at a mass ratio of at least 1% or at least 5% or at least 10%.

According to some embodiments, the lengths of the grains exceed 3 µm and the thicknesses of the grains are smaller than 2 µm. According to such embodiments, the carbon-containing powder may contain the respective grains at a mass ratio of at least 10%. Optionally, the carbon-containing powder according to such embodiments may further comprise smaller grains with extensions of less than 1 µm along any direction.

The ratio of sulfur to carbon in the mixture before it is thermally treated may refer to a ratio of elemental sulfur to elemental carbon.

The mixture may be arranged in vacuum or in an inert-gas environment while thermally treating it at the first temperature.

According to another aspect, a carbon-sulfur material contains sulfur and carbon. The carbon-sulfur material exhibits a current-voltage characteristic, wherein the voltage is zero when the current through the carbon-sulfur material is zero, and the voltage is hysteretic when the current through the carbon-sulfur material is varied and is non-zero.

The respective material exhibits the advantages laid out above in the context of the method.

The carbon-sulfur material may be obtainable by any embodiment of the method described above.

According to some embodiments, the carbon-sulfur material exhibits said current-voltage characteristic when the temperature of the carbon-sulfur material is in a first temperature range.

The first temperature range may comprise a temperature of 20 K or less.

Alternatively, or in addition, the first temperature range may range from 3 K to 20 K.

Notably, the occurrence of said current voltage characteristics is not limited to the respective (first) temperature range, but may as well occur for temperatures outside of the respective (first) temperature range.

A mass ratio of sulfur to carbon of the carbon-sulfur material may be in a range from 0.4 to 1.

According to some embodiments, a resistivity of the carbon-sulfur material at 100 K is at most 20 Ohm cm, or at most 10 Ohm cm or at most 5 Ohm cm or at most 2 Ohm cm.

A respective mass ratio of sulfur to carbon beneficially supports the formation of carbon-sulfur material with memristor properties.

The carbon-sulfur material may exhibit said current-voltage characteristics when the temperature of the carbon-sulfur material is in a second temperature range, wherein the second temperature range comprises a temperature of 180 K or more and/or wherein the second temperature range comprises a temperature of 290 K and/or wherein the second temperature range is from 200 K to 290 K.

Notably, the occurrence of said current voltage characteristics is not limited to the respective (second) temperature range, but may as well occur for temperatures outside of the respective (second) temperature range.

The current-voltage characteristics may exhibit a negative differential resistance when the current through the carbon-sulfur material passes through zero and a positive differential resistance when the current through the carbon-sulfur material passes through zero, depending on whether the current through the carbon-sulfur material is increased or decreased to pass through zero.

According to some embodiments, the carbon-sulfur material is obtainable by:
Mixing a carbon-containing powder and a sulfur-containing powder into a mixture (20), such that a mass ratio of sulfur to carbon in the mixture exceeds 0.5, and preferably is at least 2/3 or at least 1 or exceeds 1; and
thermally treating the mixture at a first temperature, thereby reducing the mass ratio of sulfur to carbon in the mixture, wherein the first temperature is in a range from 130°C to 170°C.

The mass ratio of sulfur to carbon of the carbon-sulfur material may correspond to a preselected mass ratio of sulfur to carbon. According to some embodiments, the preselected mass ratio of sulfur to carbon has been preselected to lie in between a lower mass ratio of sulfur to carbon and a higher mass ratio of sulfur to carbon, wherein a carbon-sulfur material according - as described above - with the lower mass ratio of sulfur to carbon implements a high-resistivity state or a high-resistance state, for example at a temperature of 100 K, and a carbon-sulfur material (32) - as described above -with the higher mass ratio of sulfur to carbon implements a low-resistivity state or a low-resistance state, for example at a temperature of 100 K.

According to some embodiments, the mass ratio of sulfur to carbon of the carbon-sulfur material is 2/3.

According to some embodiments, the mass ratio of sulfur to the overall mass of the carbon-sulfur material is 0.4.

According to another aspect, an electrical device comprises the carbon-sulfur material described above and at least two electrically conductive electrodes arranged in electrical contact with the carbon-sulfur material.

The electrically conductive electrodes may be metallic and/or solid. For example, they may comprise an elemental metal, for example pure or in a solid matrix or in the form of an alloy.

The electrical device may be adapted to apply a current through the carbon-sulfur material via the at least two electrically conductive electrodes.

The electrical device may further comprise at least one additional electrode or at least two additional electrodes for controlling an electrical resistance of the carbon-sulfur material, in particular of the carbon-sulfur material between the at least two electrically conductive electrodes.

Respective embodiments implement, for example, a multi-terminal (= at-least-three terminal) memristor device, with the first two terminals formed by the at least two electrically conductive electrodes, and a third (or third and fourth, respectively) terminal formed by the at least one additional electrode (or the at least two additional electrodes, respectively). A multi-terminal memristor device has advantages over a two-terminal (which is a non-multi-terminal) memristor device: The resistive switching mechanism in two-terminal memristors, which is behind the memristor functioning, remains elusive, limiting further development and improvements, and hence the performance of such devices. The scientific literature points towards ion and/or atoms diffusion affecting the electrical conduction paths. Although two-terminal memristor devices have been developed, their performance is not fully satisfactory in terms of, e.g., reliability. When applied in a computer system, two-terminal memristors often lead to computational errors, and they suffer high-power consumption. These problems are solved with the multi-terminal memristor device, i.e., with the electrical device further comprising the at least one additional electrode or the at least two additional electrodes for controlling the electrical resistance of the carbon-sulfur material.

The electrical device may be adapted to apply a voltage to the at least one additional electrode or to the at least two additional electrodes to control the electrical resistance of the carbon-sulfur material, in particular the resistance of the carbon-sulfur material between the at least two electrically conductive electrodes.

The at least one additional electrode or the at least two additional electrodes may be arranged in electrical contact with the carbon-sulfur material.

According to alternative embodiments, the at least one additional electrode or the at least two additional electrodes may be arranged in a vicinity of the carbon-sulfur material. In such embodiments, the at least one additional electrode or the at least two additional electrodes may be electric-field-coupled to the carbon-sulfur material, for example through a dielectric.

The electrical device may be adapted to control the temperature of the carbon-sulfur material to a second temperature below 170 K or below 50 K or below 20 K, or the electrical device may comprise a cooling system adapted to control the temperature of the carbon-sulfur material to the second temperature below 170 K or below 50 K or below 20 K.

Alternatively, or in addition, the electrical device may be adapted to control the temperature of the carbon-sulfur material to a third temperature above 180 K; or the electrical device may comprise the cooling system, wherein the cooling system is adapted to control the temperature of the carbon-sulfur material to the third temperature above 180 K. In such embodiments, the third temperature may be below 300 K or below 270 K or below 250 K.

Another aspect relates to the use of a carbon-sulfur material in a memristor device. The carbon-sulfur material used in the memristor device is the carbon-sulfur material described above, or carbon-sulfur material obtainable by the method described above.

Another aspect relates to the use of an electrical device as described above as/in a memristor device.

According to some embodiments, the carbon-sulfur material is at a temperature smaller than 170 K or below 50 K or below 20 K in the use of the carbon-sulfur material in the memristor device or in the use of the electrical device as described above as the memristor device.

### BRIEF DESCRIPTION OF THE FIGURES

The techniques of the present disclosure and the advantages associated therewith will be best apparent from a description of exemplary embodiments in accordance with the accompanying drawings, in which:
- Fig. 1: illustrates a method for preparing a carbon-sulfur material;
- Fig. 2: illustrates an apparatus for thermally treating the carbon-sulfur material;
- Fig. 3: gives an x-ray diffractogram of the carbon-containing powder;
- Fig. 4a: gives an electron diffraction pattern of the carbon-containing powder;
- Fig. 4b: gives a transmission electron microscopy image of the carbon-containing powder;
- Fig. 5: gives a Raman spectrum of the carbon-containing powder;
- Fig. 6: gives a scanning electron microscopy image of the carbon-containing powder;
- Fig. 7: illustrates a four-terminal device comprising the carbon-sulfur material;
- Fig. 8: gives current-voltage characteristics of the carbon-sulfur material or of the electrical device comprising it, respectively;
- Fig. 9: gives current-voltage characteristics of the carbon-sulfur material or of the electrical device comprising it, respectively;
- Fig. 10: gives current-voltage characteristics of the carbon-sulfur material or of the electrical device comprising it, respectively;
- Fig. 11: illustrates the temperature dependence of the current-voltage characteristics of the carbon-sulfur material;
- Fig. 12: compares the current-voltage characteristics of the carbon-sulfur material to mechanical properties of a ferroelectric;
- Fig. 13a to Fig. 13d: give current voltage-characteristics of devices, or of carbon-sulfur materials, respectively, according to different embodiments;
- Fig. 14a to Fig. 14c: give current voltage-characteristics of the devices, or of the carbon-sulfur materials, respectively, according to the embodiments of Fig. 13a to Fig. 13c;
- Fig. 15a to Fig. 15c: give the temperature-dependence of the resistance, the resistance, and the resistivity of devices, or of carbon-sulfur materials, respectively, according to different embodiments; and
- Fig. 16: gives the resistance as a function of temperature for devices, or for carbon-sulfur materials, respectively, according to further embodiment.

### DETAILED DESCRIPTION OF EMBODIMENTS

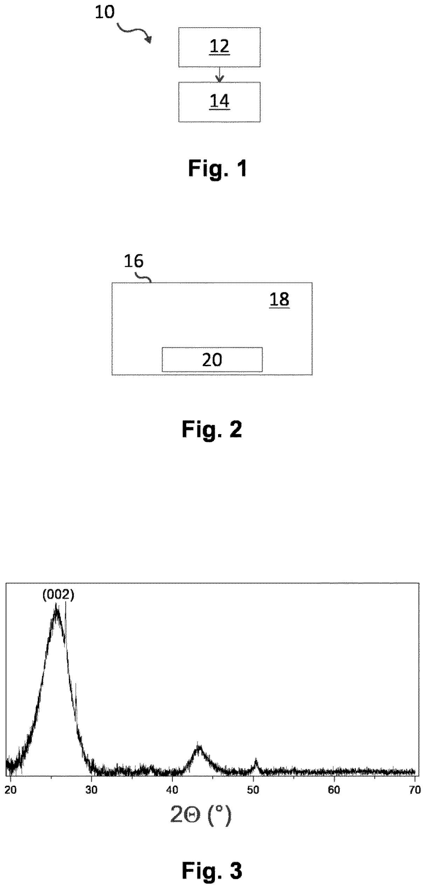

Figure 1 illustrates a method 10 for preparing a carbon-sulfur material 32.

As starter materials, the method uses a sulfur-containing powder and a carbon-containing powder.

According to the exemplary embodiment, the sulfur-containing powder is commercially available, high-purity (> 99 weight %) elemental sulfur powder.

According to the exemplary embodiment, the carbon-containing powder is a powder of Shungite, a naturally occurring form of structurally disordered, mainly sp2-hybridized carbon with a carbon content of around 98 weight %. More details about this carbon-containing powder, or the Shungite powder, respectively, will be given below in the context of Fig. 3 to Fig. 5.

At step 12, the two powders are mixed at a mass ratio of sulfur to carbon of 1. In the exemplary embodiment, the powder starter materials comprise elemental sulfur and elemental carbon, respectively, and the mass ratio can be defined as the mass of elemental sulfur in the sulfur-containing powder per mass of elemental carbon in the carbon-containing powder. In the exemplary embodiment, 61.66 mg each of carbon (in the carbon-containing powder) and of sulfur (in the sulfur-containing powder) are mixed.

Subsequently, at step 14, the resulting mixture 20 is thermally treated. For this purpose, the mixture 20 is kept in an argon atmosphere 18 at a temperature of 160° C for 20 hours.

The inventors have found that thermal treatment at temperatures in the range from 130°C to 170°C reduces the mass ratio of sulfur to carbon in the mixture.

The carbon-sulfur material 32 is given by the thermally treated mixture.

Figure 2 illustrates an apparatus 16 for performing the thermal treatment. According to the depicted embodiment, the apparatus 16 is a flux flow furnace 16. However, alternatively, a sealed ampoule 16 may be used for the apparatus 16.

Alternatively, a vacuum oven 16 may be used as the apparatus 16. In corresponding embodiments, a vacuum atmosphere 18 is used instead of the argon atmosphere 18.

The thermally treated mixture was found to contain 62 mg of carbon and 42 mg of sulfur, corresponding to a mass ratio of carbon to sulfur of about 1.5, or mass ratio of sulfur to carbon of around 2/3, respectively.

A compaction is then performed on the carbon-sulfur material 32, i.e., on the thermally treated mixture. In the example, the compaction step shapes the carbon-sulfur material 32 into a cylindrical pellet with a diameter of 5 mm and a thickness of 0.5 to 1 mm, using a mold and applying a pressure of 1 GPa. However, other shapes can be achieved as desired by the use of a corresponding mold.

Figure 3 illustrates an x-ray diffractogram of the Shungite powder used as the carbon-containing powder in the exemplary embodiment. The x-ray diffractogram was recorded in Bragg-Brentano geometry. The peak at 25.65° corresponds to a (002) reflection peak of graphite. Graphite has a layered crystallographic structure, with parallel layers of sp2-hybridized carbon. The (002) reflection peak is indicative of an interlayer distance d = 0.347 nm between neighboring layers of sp2-hybridized carbon. This value is considerably bigger than the interlayer distance of 0.335 nm of ideal (Bernal) graphite. The larger value of 0.347 nm is similar to the one of so-called turbostratic graphite or twisted multilayer graphene, as presented, e.g., in E. Tamburri et al., Inorg. Chem. 57,8487 (2018). The inventors hypothesize that the large interlayer distance is beneficial for the nonlinear resistance and the memristive properties of the sulfur-carbon material resulting from the preparation method.

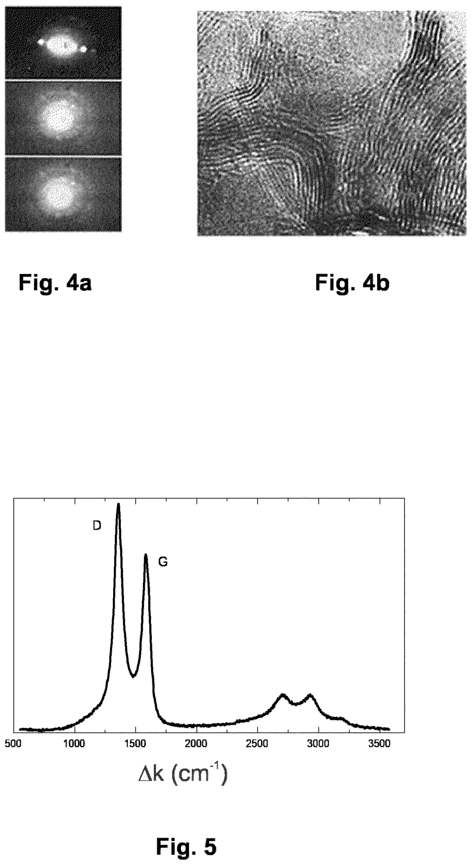

Fig. 4a shows an electron diffraction pattern of the Shungite powder used as the carbon-containing powder in the exemplary embodiment, and Fig. 4b gives a transmission electron microscopy image of the same powder. The image in Fig. 4b covers a width of 0.7 nm and a height of 0.5 nm.

Fig. 4a and Fig. 4b demonstrate that the Shungite powder contains carbon material with carbon layers similar to the ones forming graphite. However, the Shungite powder contains curved carbon layers with radii of 5 - 15 nm, whereas the carbon layers of graphite are flat. The structure of the carbon layers in the Shungite powder is similar to the structure of multilayer fullerenes with diameters of 10-30 nm.

The inventors hypothesize that the curved carbon layers are beneficial for the nonlinear resistance and the memristive properties of the sulfur-carbon material resulting from the preparation method.

Figure 5 gives a Raman spectrum of the Shungite powder used as the carbon-containing powder in the exemplary embodiment.

The Raman spectrum of Fig. 5 shows a peak D (also known in the scientific literature as D line) at a Raman shift Δk of 1358 cm⁻¹, and another peak G (also known in the scientific literature as G line) characteristic for graphite and/or sp2-hybridized carbon. The peak D is related to the presence of sp3-hybridized carbon and/or of disorder in the sp2-hybridized carbon.

The Raman spectrum of Fig. 5 is indicative of structural disorder of the Shungite material (as compared to ideal graphite) and of the presence of sp3-hybridized carbon.

The inventors hypothesize that the presence of structural disorder and/or of sp3-hybridized carbon is beneficial for the nonlinear resistance and the memristive properties of the sulfur-carbon material resulting from the preparation method.

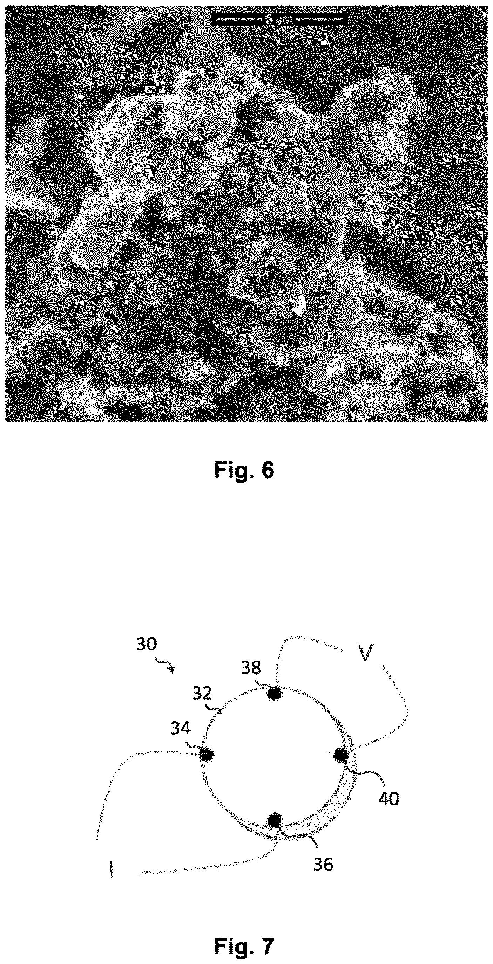

Figure 6 gives a scanning electron microscopy image of the Shungite powder used as the carbon-containing powder in the exemplary embodiment.

The Shungite powder comprises a significant percentage (10 weight % or more) of grains with a size of approximately 10 × 5 × 0.1 µm³. Moreover, the Shungite powder comprises grains of smaller sizes, with extensions of < 1 µm along any direction.

Figure 7 schematically illustrates an electrical device 30 comprising the carbon-sulfur material 52.

To form the electrical device 30, the carbon-sulfur material 32 was shaped into a cylindrical pellet with a diameter of 5 mm. Electrically conductive electrodes 34, 36 and additional electrodes 38, 40 were deposited from silver-containing epoxy glue. The spacing between any pair of the electrodes 34, 36, 38, 40 is 1 to 2 mm.

The electrical device 30 implements a four-terminal memristor. During the use as a four-terminal memristor, a voltage is applied between the additional electrodes 38, 40 to control the electrical resistance of the carbon-sulfur material 32. The electrically conductive electrodes 34, 36 are used to electrically contact the carbon-sulfur material 32 and send a probe current through it.

For the use of the device as a resistor with a negative capacitance, a current may be sent through the carbon-sulfur material 32 via the electrically conductive electrodes 34, 36 or via the additional electrodes 38, 40.

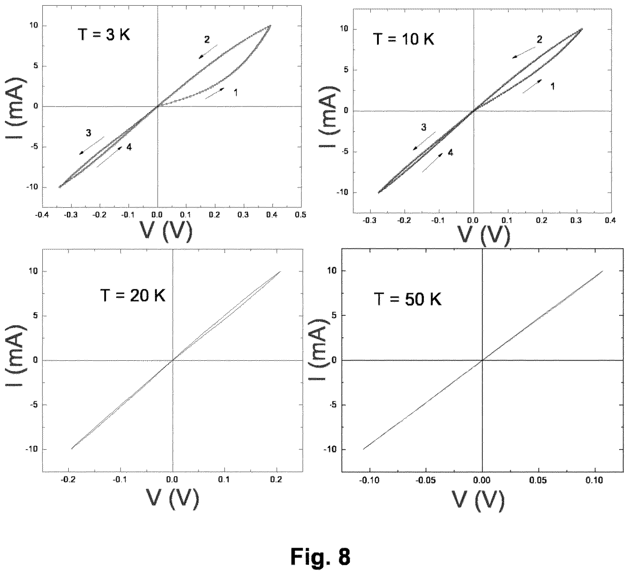

Fig. 8 to Fig. 12 present an electrical characterization of the device 30. The carbon-sulfur material of the respective device comprises 40 weight % (with respect to the overall mass of the carbon-sulfur material) sulfur, and 60 weight % (with respect to the overall mass of the carbon-sulfur material) carbon. The mass ratio of sulfur to carbon of the respective carbon-sulfur material is 2/3.

For the measurements of Fig. 8 to Fig. 12, a current is applied between the conductive electrodes 34, 36. The resulting voltage is measured between the additional electrodes 38, 40.

Fig. 8, Fig. 9, and Fig. 10 show current-voltage characteristics of a device 30, or of a carbon-sulfur material 32, respectively, according to a first embodiment. The current-voltage characteristics are given for different temperatures T of the carbon-sulfur material 32. The horizontal axis V(V) depicts the measured voltage in Volts between the additional electrodes 38, 40. The vertical axis I(mA) depicts the current in milli-Amperes flowing through the device 30 via the electrically conductive electrodes 34, 36.

Fig. 8 depicts the current-voltage characteristics at low temperatures T of the carbon-sulfur material 32, namely at T = 3 K, T = 10 K, T = 20 K, and T = 50 K.

During the measurements, the current sent through the device 32 via the electrically conductive electrodes 34, 36 was varied along the path 1 → 2 → 3 → 4 indicated in Fig. 8.

At temperatures up to 20 K (i.e., at 3 K, 10 K, and 20 K), the carbon-sulfur material 32, or the device 30, respectively, exhibits the current-voltage characteristics characteristic for a memristor, namely a "pinched hysteresis loop" characterized by a voltage V(V) of zero when the current I(mA) through the carbon-sulfur material 32 is zero, and a hysteretic voltage V(V) when the current I(mA) through the carbon-sulfur material 32 is varied and is non-zero. The hysteresis is stronger for lower temperatures of the carbon-sulfur material 32.

Even if not well visible in Fig. 8 for T = 50 K, a minor hysteresis is present also in the measurement at this temperature. However, a stronger hysteresis and a more pronounced memristor behavior is observed for temperatures of up to 20 K, indicating that the material is particularly suitable for use as a memristor at temperatures of up to 20 K.

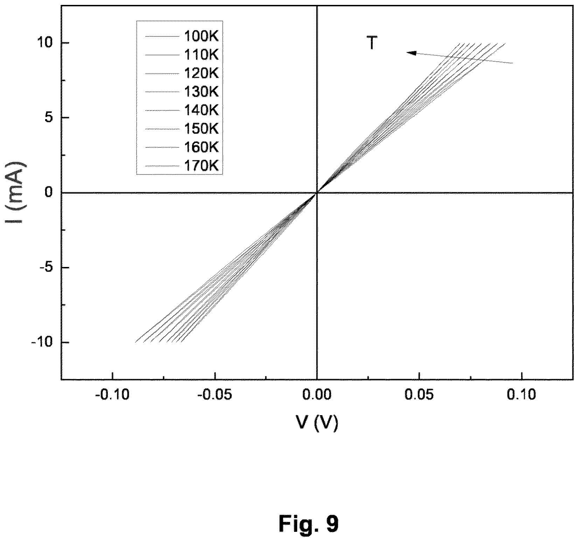

As Fig. 9 illustrates, no significant hysteresis is detected for device temperatures in the range from 100 K to 170 K. Like in the current-voltage characteristics of Fig. 8 for 50 K, a minor is present in all current-voltage characteristics of Fig. 9, i.e., for temperatures T of the carbon-sulfur material 32 of 100 K, 110 K, 120 K, 130 K, 140 K, 150 K, 160 K, and 170 K, even though the hysteresis is significantly smaller than the one measured at 20 K or at 10 K.

As Fig. 8 and Fig. 9 demonstrate, cooling the device 30 to a temperature of no more than 20 K (for which the hysteresis is well visible in Fig. 8) or a temperature below 10 K (for which the hysteresis is even more pronounced) is beneficial for the use of the device 32 as a memristor.

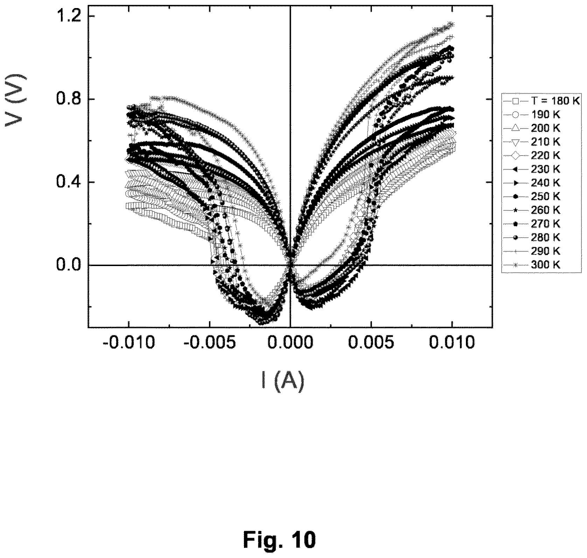

Fig. 10 depicts current-voltage characteristics measured on the same device 30 with the temperature T of the carbon-sulfur material 32 in the range from 180 K to 300 K.

The current-voltage characteristics of Fig. 10 differ qualitatively from the ones of Fig. 8 and Fig. 9, but they also show the "pinched hysteresis loop" characteristic for a memristor, with a voltage V(V) of zero when the current I(A) through the carbon-sulfur material 32 is zero, and a hysteretic voltage V(V) when the current I(A) through the carbon-sulfur material 32 is varied and is non-zero.

The current-voltage characteristics of Fig. 10 show only a weak temperature dependence. The device 30 is well suitable for the use as a memristor for all temperatures of the carbon-sulfur material 32 depicted in Fig. 10, i.e. for temperatures of the carbon-sulfur material 32 in the range from 180 K to 300 K.

The current-voltage characteristics of Fig. 10 show a "butterfly" shape.

In particular, they include, for specific measurement conditions, a negative differential resistance, i.e., a negative slope of the current-voltage characteristics, namely, when the current-voltage characteristics pass from the second quadrant (V(V) > 0, I(A) < 0) through the origin (V(V) = 0, I(A) = 0) to the fourth quadrant (V(V) < 0, I(A) > 0).

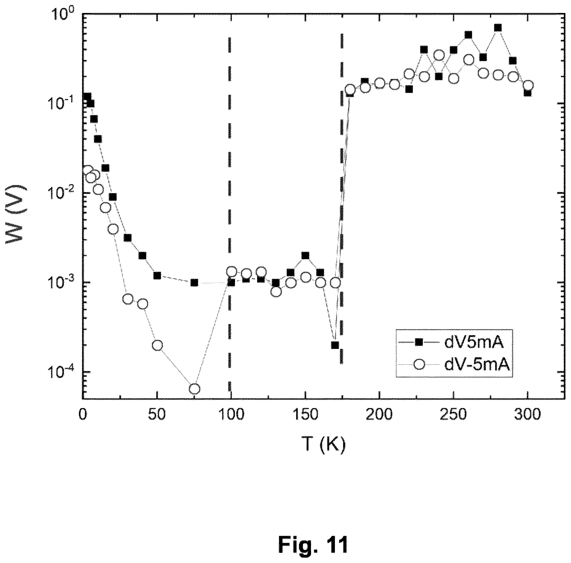

Fig. 11 further illustrates the temperature dependence of the electrical properties of the device 30 according to the first embodiment, that the measurements of Fig. 8 to Fig. 10 were performed on.

In Fig. 11, the measured hysteresis width W(V) is depicted for a small (5 mA) positive current (black squares) and for a small (-5 mA) negative current (open circles). The hysteresis width W(V) is defined by the intersections of a vertical line at the respective small positive/negative current with the current-voltage curves, namely as the absolute value of the difference between the voltages at the two occurring intersections (for either one of the small positive/negative currents).

The transition between the current-voltage characteristics of Fig. 8, Fig. 9 and the ones of Fig. 10 is reflected in an increase of the hysteresis width W(V) by around two orders of magnitude at around 175 K, consistent for the small positive current and for the small negative current.

This significant increase of the hysteresis width W(V) as well as the qualitative change of the measured current-voltage characteristics suggests the occurrence of a phase transition at T = 175 K in the electronic system of the carbon-sulfur material 32 according to the first embodiment.

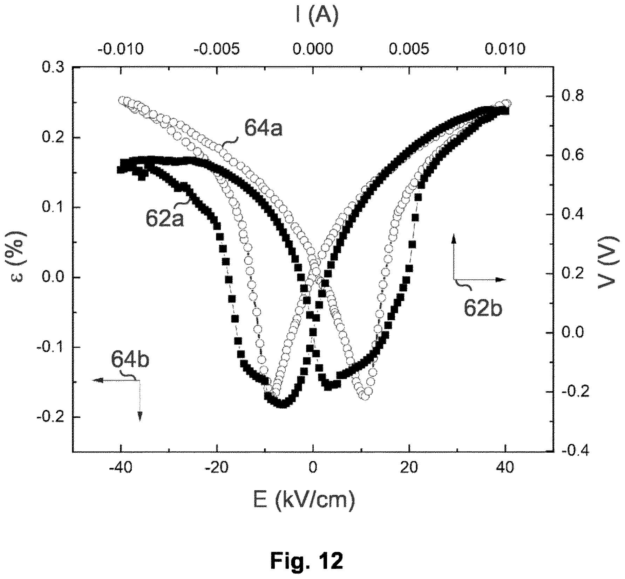

Fig. 12 compares the current-voltage characteristics 62a of the carbon-sulfur material 32 according to the first embodiment to the mechanical strain ε, 64a occurring in a ferroelectric material when an electric field of magnitude E is applied to the ferroelectric.

In Fig. 12, the upper and right axis 62b correspond to the current-voltage characteristics 62a of the carbon-sulfur material 32 made from the Shungite powder. The bottom and left axis 64b correspond to the magnitude E of the electric field applied to the ferroelectric material, and to the mechanical strain ε, 64a in the ferroelectric material, respectively.

During the measurements, the temperature of the current-voltage characteristics of the carbon-sulfur material 32 was T = 250 K. The measurement of the mechanical strain ε(E) is taken from A. Kumar et al., Energies 13, 6457 (2020) for the PLZT ferroelectric ceramics.

As illustrated in Fig. 12, the inventors found a striking similarity between the current-voltage characteristics 62a of the carbon-sulfur material 32 according to the first embodiment (measured at a temperature T in the range from 180 K to 300 K, Fig. 10) and the mechanical strain ε occurring in the ferroelectric material.

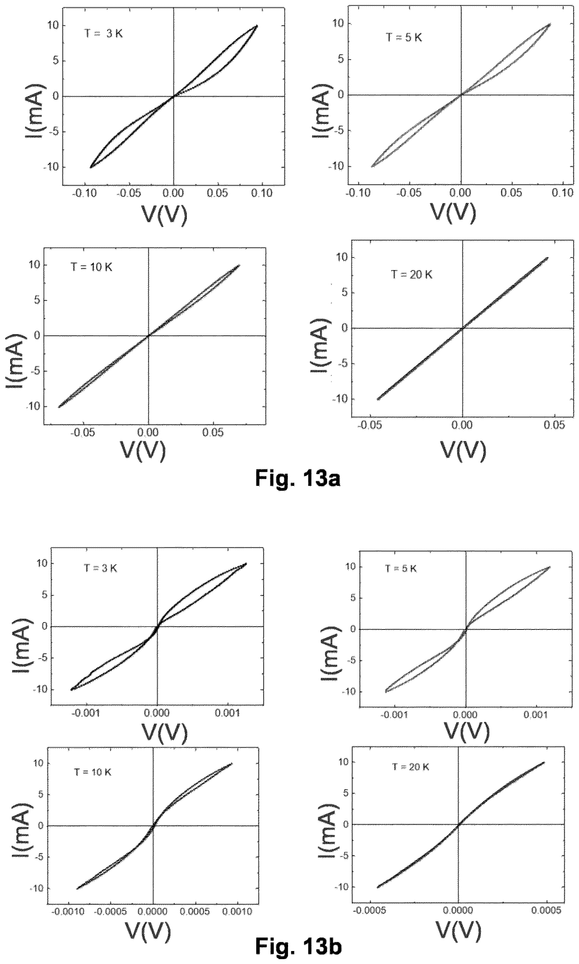

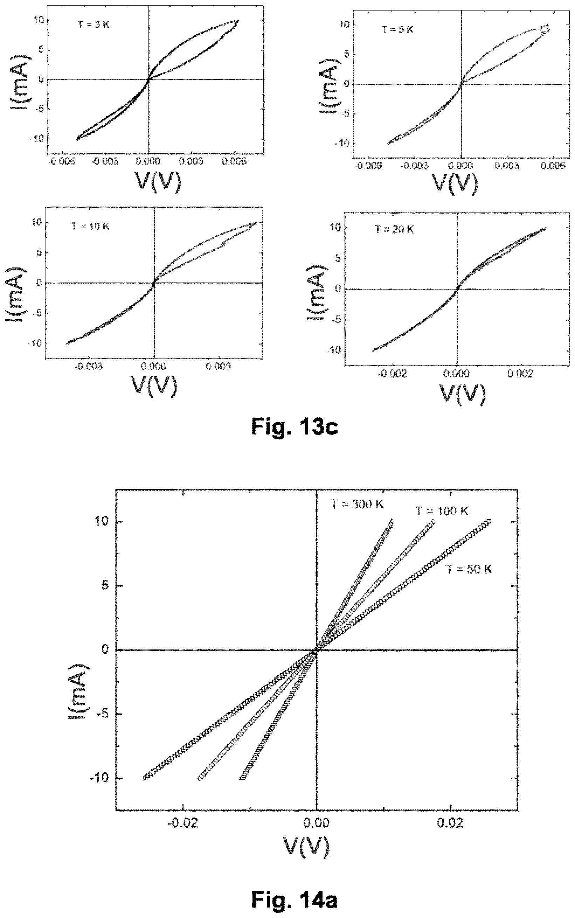

Fig. 13a, Fig. 13b, and Fig. 13c give current voltage-characteristics of devices 30, or of carbon-sulfur materials 32, respectively, according to further embodiments. The current voltage-characteristics are given for temperatures of the devices 30, or of the carbon-sulfur materials 32, respectively, of up to 20 K, namely for 3 K, 5 K, 10 K, and 20 K as indicated in Fig. 13a, Fig. 13b, and Fig. 13c.

Fig. 13a shows current voltage-characteristics at different temperatures (3 K, 5 K, 10 K, and 20 K) for a device 30, or a carbon-sulfur material 32, respectively, according to a second embodiment. The carbon-sulfur material according to the second embodiment comprises 32 weight % (with respect to the overall mass of the carbon-sulfur material) sulfur, and 68 weight % (with respect to the overall mass of the carbon-sulfur material) carbon. The mass ratio of sulfur to carbon of the respective carbon-sulfur material is 0,47.

Fig. 13b gives corresponding current voltage-characteristics for a device 30, or a carbon-sulfur material 32, respectively, according to a third embodiment. The carbon-sulfur material according to the third embodiment comprises 41 weight % (with respect to the overall mass of the carbon-sulfur material) sulfur, and 59 weight % (with respect to the overall mass of the carbon-sulfur material) carbon. The mass ratio of sulfur to carbon of the respective carbon-sulfur material is 0,69.

Fig. 13c gives corresponding voltage-characteristics for a device 30, or a carbon-sulfur material 32, respectively, according to a fourth embodiment. The carbon-sulfur material according to the fourth embodiment comprises 44 weight % (with respect to the overall mass of the carbon-sulfur material) sulfur, and 56 weight % (with respect to the overall mass of the carbon-sulfur material) carbon. The mass ratio of sulfur to carbon of the respective carbon-sulfur material is 0,79.

The current voltage-characteristics shown in Fig. 13a, Fig.13b, and Fig. 13c have been recorded in a similar manner as the current voltage-characteristics shown in Fig. 8. To avoid repetition, experimental details are not repeated, but reference is made to Fig. 8 above.

As Fig. 13a, Fig. 13b, and Fig. 13c demonstrate, the devices 30, or the carbon-sulfur materials 32, respectively, according to any of the second, third and fourth embodiment exhibit at temperatures of up to at least 20 K the current-voltage characteristics of a memristor, namely a "pinched hysteresis loop" characterized by a voltage V(V) of zero when the current I(mA) through the carbon-sulfur material 32 is zero, and a hysteretic voltage V(V) when the current I(mA) through the carbon-sulfur material 32 is varied and is non-zero. It may be expected that similar carbon-sulfur materials with a mass ratio of sulfur to carbon in between the one of the second embodiment (i.e., 0,47) and the one of the fourth embodiment (i.e., 0,79) also show memristor behavior.

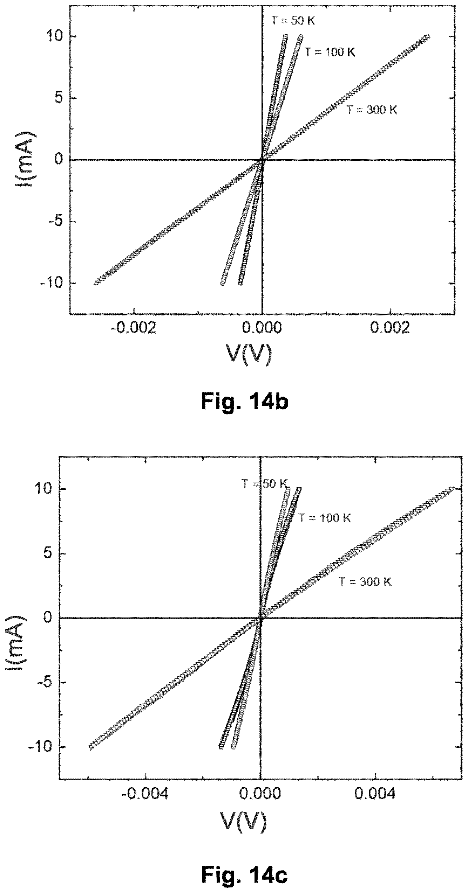

Fig. 14a, Fig. 14b, and Fig. 14c give current voltage-characteristics of the devices 30, or of the carbon-sulfur materials 32, respectively, according to the second, third, and fourth embodiment as described above in the context of Fig. 13a, Fig. 13b, and Fig. 13c. The current voltage-characteristics are given for temperatures of the devices 30, or of the carbon-sulfur materials 32, respectively, of up to 300 K, namely for 50 K, 100 K, and 300 K as indicated in the figures.

Fig. 14a shows the current voltage-characteristics of the device 30, or of the carbon-sulfur material 32, respectively, according to the second embodiment described above in the context of Fig. 13a.

Fig. 14b shows the current voltage-characteristics of the device 30, or of the carbon-sulfur material 32, respectively, according to the third embodiment described above in the context of Fig. 13b.

Fig. 14c shows the current voltage-characteristics of the device 30, or of the carbon-sulfur material 32, respectively, according to the fourth embodiment described above in the context of Fig. 13c.

As Fig. 14a, Fig.14b, and Fig. 14c illustrate, no significant hysteresis is detected for temperatures of the respective devices in the range from 50 K to 300 K.

As Fig. 13a, Fig.13 b, and Fig. 13c in combination with Fig. 14a, Fig. 14b, and Fig. 14c demonstrate, cooling the devices 30 according to the second, third, and fourth embodiments to a temperature of 20 K or below (for which the hysteresis is well visible in Fig. 13a, Fig.13b, and Fig. 13c) or a temperature of 10 K or below (for which the hysteresis is even more pronounced) is beneficial for the use of the device 32 as a memristor.

In contrast, the device 30 according to the first embodiment shows memristor behavior not only at low temperature (< 20 K) but also at higher temperatures (180 K and above, up to at least 300 K), cf. Fig. 8 and Fig. 10.

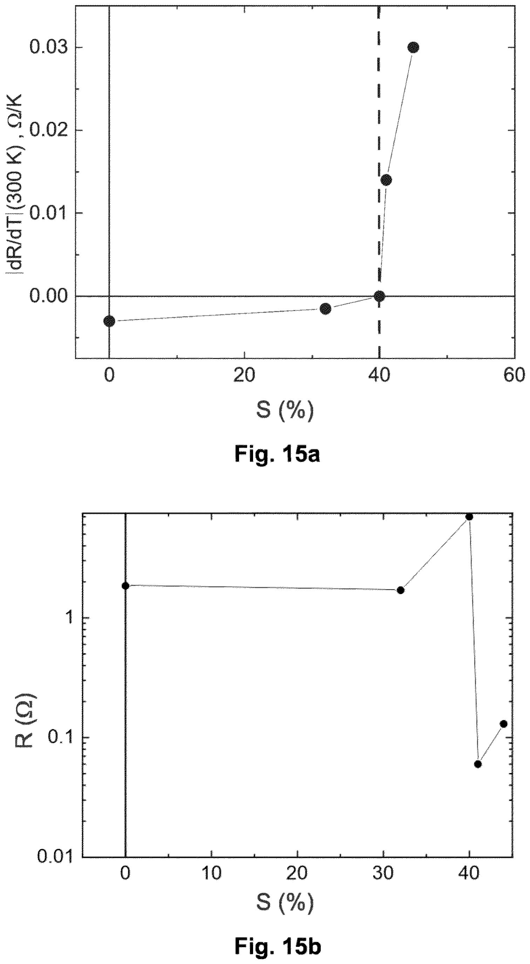

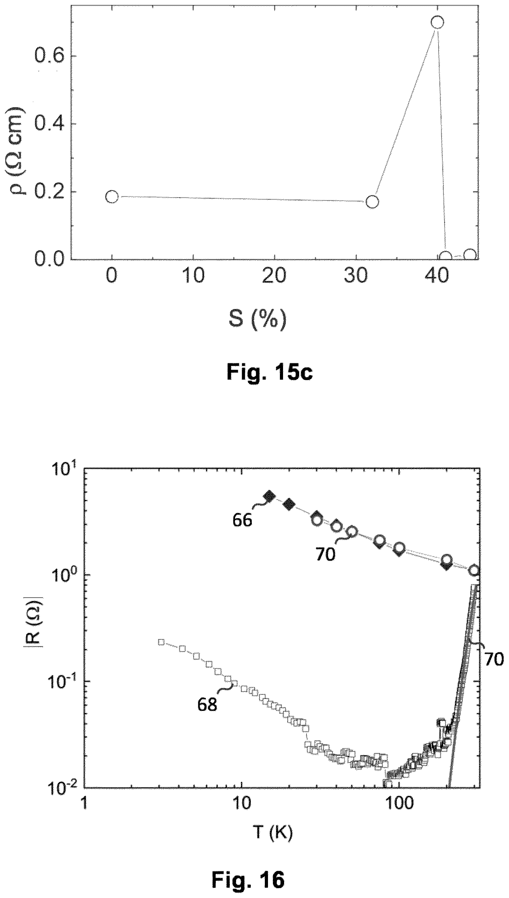

Fig. 15a, Fig. 15b, and Fig. 15c give the temperature-dependence of the resistance, the resistance, and the resistivity of the devices according to the first to fourth embodiments and of a reference device with a sulfur content of zero. In the context of Fig. 15a, Fig.15b, and Fig. 15c, R refers to the resistance (in Ω), T to the temperature (in K), ρ to the resistivity (in Ω cm), and S to the sulfur content in weight % (with respect to the overall mass of the carbon-sulfur material). The mass ratios of sulfur to carbon corresponding to the sulfur contents S indicated in Fig. 15a, Fig.15b, and Fig. 15c are given above in the context of Fig. 13a, Fig.13b, and Fig. 13c.

Fig. 15a gives the derivative |dR/dT| as a function of the sulfur content S of the devices 30, or of the carbon-sulfur materials 32, respectively, at a temperature of 300 K. The resistance R has been determined as the ratio |U/I| for a voltage U and a current I close to zero.

Fig. 15b gives the resistance R as a function of the sulfur content S of the devices 30, or of the carbon-sulfur materials 32, respectively, at a temperature of 100 K. The resistance R has been determined as the ratio |U/I| for a voltage U and a current I close to zero.

Fig. 15c gives the resistivity ρ as a function of the sulfur content S of the devices 30, or of the carbon-sulfur materials 32, respectively, at a temperature of 100 K. The resistivity ρ has been determined from the ratio |U/I| for a voltage U and a current I close to zero, taking into account the physical dimensions of the devices 30.

As Fig. 15a, Fig. 15b, and Fig. 15c demonstrate, the carbon-sulfur material with a sulfur contents S, or a mass ratio of sulfur to carbon, respectively, below the one of the first embodiment (i.e., S = 0.40, or mass ratio of sulfur to carbon = 2/3, respectively) implements a high-resistivity state, or a high-resistance state, respectively. In particular, the carbon-sulfur material according to the second embodiment implements the high-resistance state.

In contrast, the carbon-sulfur materials with a sulfur contents S, or a mass ratio of sulfur to carbon, respectively, above the one of the first embodiment (i.e., S = 0.40, or mass ratio of sulfur to carbon = 2/3, respectively) implements a low-resistivity state, or a low-resistance state, respectively. In particular, the carbon-sulfur materials according to the third and fourth embodiment implement the low-resistance state.

In this context, the terms "high resistivity"/"high resistance" and "low resistivity" j"low resistance" are to be understood relative to each other, i.e., the high resistivity/high resistance is significantly larger than the low resistivity/low resistance. According to the example of Fig. 15b, the relative difference amounts to more than a factor of 10.

Fig. 16 gives the resistance R as a function of temperature T (in K) for devices 30/carbon-sulfur materials 32 according to the second embodiment 66 (full diamonds) with S = 0.32 implementing the high-resistivity state/high-resistance state, according to the fourth embodiment 68 (open squares) with S = 0.44 implementing the low-resistivity state/low-resistance state, and for the reference device/carbon material without sulfur 70 (open circles).

The resistance R of the device 30/carbon-sulfur material 32 according to the second embodiment 66 decreases with temperature T, as is typical for an insulator, or a semiconductor, respectively. Similarly, the resistance R of the reference device/carbon material 70 without sulfur decreases with temperature T.

In contrast, for temperatures T > 80 K, the resistance R of the device 30/carbon-sulfur material 32 according to the fourth embodiment 68 increases with temperature T, as is typical for a metal.

In this sense, the high-resistivity state/high-resistance state is an insulator-, or semiconductor-type state, and the low-resistivity state/low-resistance state is a metal-type state.

The device 30/carbon-sulfur material 32 according to the first embodiment has a sulfur content, or a mass ratio of sulfur to carbon, respectively, in between the one implementing the high-resistivity state/high-resistance state and the one implementing the low-resistivity state/low-resistance state. In other words, the device 30/carbon-sulfur material 32 according to the first embodiment has a sulfur content, or a mass ratio of sulfur to carbon, respectively, in between the one of the insulator-, or semiconductor-type state and the one of the metal-type state. A device 30/carbon-sulfur material 32 with a respective sulfur content, or a corresponding mass ratio of sulfur to carbon, respectively, beneficially implements (1) the memristive behavior at temperatures above 180 K and up to room temperature/300 K, and (2) butterfly-type current-voltage characteristics, i.e., a negative differential resistance when the current (I(mA), I(A)) through the carbon-sulfur material (32) passes through zero and a positive differential resistance when the current (I(mA), I(A)) through the carbon-sulfur material (32) passes through zero, depending on whether the current (I(mA), I(A)) through the carbon-sulfur material (32) is increased or decreased to pass through zero.

## Claims

1. A carbon-sulfur material (32) containing sulfur and carbon,
wherein the carbon-sulfur material (32) exhibits a current-voltage characteristic;
wherein the voltage (V(V)) is zero when the current (I(mA), I(A)) through the carbon-sulfur material (32) is zero; and
wherein the voltage (V(V)) is hysteretic when the current (I(mA), I(A)) through the carbon-sulfur material (32) is varied and is non-zero.

2. The carbon-sulfur material (32) according to claim 1, wherein the carbon-sulfur material (32) exhibits said current-voltage characteristic when the temperature of the carbon-sulfur material (32) is in a first temperature range,
wherein the first temperature range comprises a temperature of 20 K or less, or wherein the first temperature range is from 3 K to 20 K.

3. The carbon-sulfur material (32) according to claim 1 or 2,
wherein a mass ratio of sulfur to carbon of the carbon-sulfur material (32) is in a range from 0.4 to 1; and/or
wherein a resistivity of the carbon-sulfur material (32) at 100 K is at most 20 Ohm cm, or at most 10 Ohm cm or at most 5 Ohm cm or at most 2 Ohm cm or at most 0.7 Ohm cm.

4. The carbon-sulfur material (32) according to any of claims 1 to 3,
wherein the carbon-sulfur material (32) exhibits said current-voltage characteristic when the temperature of the carbon-sulfur material (32) is in a second temperature range, wherein the second temperature range comprises a temperature of 180 K or more and/or wherein the second temperature range comprises a temperature of 290 K and/or wherein the second temperature range is from 200 K to 290 K; and/or
wherein the current-voltage characteristics exhibits a negative differential resistance when the current (I(mA), I(A)) through the carbon-sulfur material (32) passes through zero and a positive differential resistance when the current (I(mA), I(A)) through the carbon-sulfur material (32) passes through zero, depending on whether the current (I(mA), I(A)) through the carbon-sulfur material (32) is increased or decreased to pass through zero.

5. The carbon-sulfur material (32) according to any of the preceding claims, wherein the carbon-sulfur material (32) is obtainable by:
mixing (12) a carbon-containing powder and a sulfur-containing powder into a mixture (20), such that a mass ratio of sulfur to carbon in the mixture (20) exceeds 0.5, and preferably is at least 2/3 or at least 1; and
thermally treating (14) the mixture (20) at a first temperature, thereby reducing the mass ratio of sulfur to carbon in the mixture (20), wherein the first temperature is in a range from 130°C to 170°C.

6. The carbon-sulfur material (32) according to any of the preceding claims,
wherein the mass ratio of sulfur to carbon of the carbon-sulfur material (32) corresponds to a preselected mass ratio of sulfur to carbon, wherein the preselected mass ratio of sulfur to carbon has been preselected to lie in between a lower mass ratio of sulfur to carbon and a higher mass ratio of sulfur to carbon, wherein a carbon-sulfur material (32) according to any of the preceding claims with the lower mass ratio of sulfur to carbon implements a high-resistivity state or a high-resistance state, for example at a temperature of 100 K, and a carbon-sulfur material (32) according to any of the preceding claims with the higher mass ratio of sulfur to carbon implements a low-resistivity state or a low-resistance state, for example at a temperature of 100 K; and/or
wherein the mass ratio of sulfur to carbon of the carbon-sulfur material (32) is 2/3.

7. An electrical device (30) comprising the carbon-sulfur material (32) according to any of the preceding claims s and at least two electrically conductive electrodes (34, 36) arranged in electrical contact with the carbon-sulfur material (32);
in particular:
wherein the electrically conductive electrodes (34, 36) are metallic and/or solid; and/or
wherein the electrical device (30) is adapted to apply a current through the carbon-sulfur material (32) via the at least two electrically conductive electrodes (34,36).

8. The electrical device (30) of claim 7, which further comprises at least one additional electrode (38, 40) or at least two additional electrodes (38, 40) for controlling an electrical resistance of the carbon-sulfur material (32), wherein the at least one additional electrode (38, 40) or the at least two additional electrodes (38, 40) is/are arranged in electrical contact with the carbon-sulfur material (32), in particular, wherein the electrical device (30) is adapted to apply a voltage (V(V)) to the at least one additional electrode or to the at least two additional electrodes to control the electrical resistance of the carbon-sulfur material (32).

9. A method (10) for preparing a carbon-sulfur material (32), the method (10) comprising:
mixing (12) a carbon-containing powder and a sulfur-containing powder into a mixture (20), such that a mass ratio of sulfur to carbon in the mixture (20) is at least 0.5; and
thermally treating (14) the mixture (20) at a first temperature, thereby reducing the mass ratio of sulfur to carbon in the mixture (20), wherein the first temperature is in a range from 130°C to 170°C.

10. The method (10) according to claim 9,
wherein the mass ratio of sulfur to carbon in the mixture (20) prior to thermally treating (14) the mixture (20) at the first temperature is at least 2/3 or at least 1, or wherein the mass ratio of sulfur to carbon in the mixture (20) prior to thermally treating (14) the mixture (20) at the first temperature is in a range from 0.5 to 2 or is in a range from 1 to 2 or is in a range from 0.5 to 1.8; and/or
wherein the process step of thermally treating (14) the mixture (20) at the first temperature is performed for at least 5 minutes, or for at least 10 minutes, or for at least 15 minutes, or for at least 20 minutes, or for at least 30 minutes, or for at least 1 hour, or for at least 2 hours, or for at least 5 hours, or for at least 10 hours, or for at least 15 hours, or for at least 20 hours; and/or
wherein the ratio of sulfur to carbon in the mixture (20) before it is thermally treated refers to a ratio of elemental sulfur to elemental carbon; and/or
wherein thermally treating (14) the mixture (20) at the first temperature produces the carbon-sulfur material (32) according to any of claims 1-6.

11. The method (10) according to claim 9 or 10,
wherein the process step of thermally treating (14) the mixture (20) at the first temperature is performed for a first duration; and
wherein the first temperature and the first duration are selected such that, after thermally treating (14) the mixture (20) at the first temperature, the mass ratio of sulfur to carbon of the carbon-sulfur material (32) corresponds to a preselected mass ratio of sulfur to carbon,
wherein the preselected mass ratio of sulfur to carbon is in a range from 0.4 to 1; or the preselected mass ratio of sulfur to carbon is 2/3; or the preselected mass ratio of sulfur to carbon has been preselected to lie in between a lower mass ratio of sulfur to carbon and a higher mass ratio of sulfur to carbon, wherein a carbon-sulfur material (32) according to any claims 1 - 6 with the lower mass ratio of sulfur to carbon implements a high-resistivity state or a high-resistance state, for example at a temperature of 100 K, and a carbon-sulfur material (32) according to any claims 1-6 with the higher mass ratio of sulfur to carbon implements a low-resistivity state or a low-resistance state, for example at a temperature of 100 K.

12. The method (10) according to any of claims 9 - 11,
which further comprises performing a compaction of the thermally treated mixture (32); and/or
which further comprises providing at least two electrically conductive electrodes (34, 36, 38, 40) or at least four electrically conductive electrodes (34, 36, 38, 40) in electrical contact with the thermally treated mixture (32).

13. The method (10) according to any of claims 9 to 12,
wherein the sulfur-containing powder contains elemental sulfur, in particular, at a weight percentage of at least 50% or at least 95%; and/or
wherein the carbon-containing powder contains elemental carbon, in particular, at a weight percentage of at least 50% or at least 95%.

14. The method (10) according to any of claims 9 - 13,
wherein the carbon-containing powder contains a plurality of layers comprising sp2-hybridized carbon, wherein the plurality of layers comprising sp2-hybridized carbon comprises neighboring layers; wherein, optionally, a distance between the neighboring layers exceeds 0.34 nm or 0.345 nm along a direction of a surface normal of at least one of the neighboring layers; and/or wherein, optionally, the neighboring layers are curved; and/or
wherein the carbon-containing powder contains sp2-hybridized carbon and sp3-hybridized carbon; and/or
wherein the carbon-containing powder comprises or is composed of Shungite and/or carbon-containing material mined in Karelia, Russia; and/or
wherein the carbon-containing powder contains grains, wherein lengths of the grains exceed 3 µm and thicknesses of the grains are smaller than 2 µm; and/or
wherein the mixture (20) is arranged in vacuum (18) or in an inert-gas environment (18) while thermally treating it at the first temperature.

15. Use of the carbon-sulfur material (32) according to any of claims 1 - 6 or of the electrical device (30) according to any of claims 7 or 8 in a memristor device.
